Europäisches Patentamt

European Patent Office

Office européen des brevets

(19)

(11) Numéro de publication : **0 092 276**

**B1**

(12)

# FASCICULE DE BREVET EUROPÉEN

(45) Date de publication du fascicule du brevet :
26.03.86

(21) Numéro de dépôt : 83200522.7

(22) Date de dépôt : 13.04.83

(51) Int. Cl.⁴ : **G 09 G   1/16, G 01 R 13/40**

(54) **Dispositif d'affichage à balayage récurrent entrelacé de type télévision et oscilloscope numérique comprenant un tel dispositif.**

(30) Priorité : 16.04.82 FR 8206589
16.03.83 FR 8304281

(43) Date de publication de la demande :
26.10.83 Bulletin 83/43

(45) Mention de la délivrance du brevet :
26.03.86 Bulletin 86/13

(84) Etats contractants désignés :
DE FR GB

(56) Documents cités :
FR-A- 2 489 633

(73) Titulaire : **Laboratoires d'Electronique et de Physique Appliquée L.E.P.**
**3, Avenue Descartes**
**F-94450 Limeil-Brévannes (FR)**
**FR**
**N.V. Philips' Gloeilampenfabrieken**
**Groenewoudseweg 1**
**NL-5621 BA Eindhoven (NL)**
**DE GB**

(72) Inventeur : **Dureux, Pierre Joseph Charles**
**Société Civile S.P.I.D. 209 rue de l'Université**
**F-75007 Paris (FR)**

(74) Mandataire : **Landousy, Christian et al**
**Société Civile S.P.I.D. 209, Rue de l'Université**
**F-75007 Paris (FR)**

## Description

La présente invention concerne un dispositif d'affichage à balayage récurrent entrelacé de type télévision, ainsi qu'un oscilloscope numérique comprenant un tel dispositif.

L'une des caractéristiques d'un oscilloscope numérique est que le signal analogique en temps réel est d'abord échantillonné puis mis en mémoire numérique avant d'être restitué. A la restitution, pour éviter que l'opérateur ne relie à son insu deux échantillons proches sur l'écran mais en réalité non successifs dans le temps, une interpolation est prévue entre échantillons successifs (par exemple sous la forme d'échantillons supplémentaires) pour lever les incertitudes relatives à l'interprétation des images affichées (voir par exemple les brevets français N° 2 463 964 ou 2 489 633). L'interpolation la plus simple est l'interpolation linéaire qui consiste à construire sur l'écran d'affichage un vecteur ayant ses extrémités en coïncidence avec les points représentatifs des échantillons présents en mémoire.

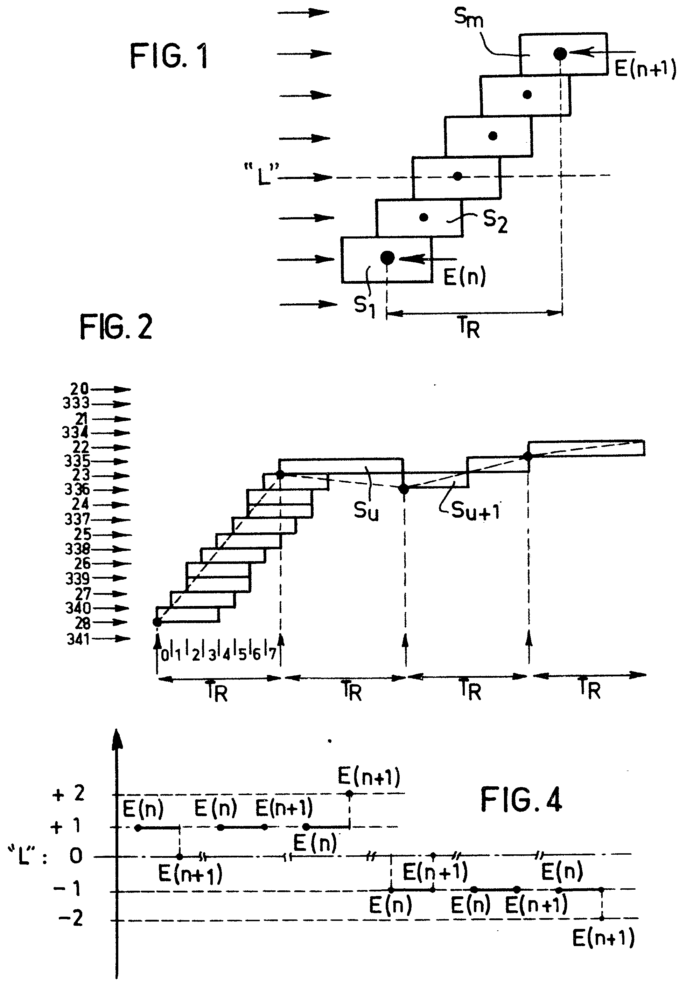

Au cours du balayage d'un dispositif d'affichage de type télévision, la surface de l'écran est balayée horizontalement à vitesse régulière ligne après ligne, ce qui implique une numérisation verticale de l'information. Les extrémités du vecteur d'interpolation sont donc situées généralement sur des lignes de balayage différentes et non contiguës. Le principe de cette interpolation apparaît nettement sur la figure 1 : la nature discrète de la résolution verticale impose la construction dudit vecteur à l'aide de petits segments horizontaux $S_1$ à $S_m$ portés par les lignes intermédiaires disponibles (correspondant aux flèches présentes du côté gauche de la figure) et présentant entre eux un certain recouvrement en projection horizontale pour assurer une continuité apparente du vecteur d'interpolation. Le nombre de ces lignes intermédiaires disponibles dépend de l'écart d'amplitude entre deux échantillons successifs $E(n)$ et $E(n + 1)$.

Dans le cas où il n'y a pas de ligne de balayage disponible entre deux positions d'échantillons, le vecteur d'interpolation comprend un segment d'interpolation unique qui dure une période de restitution complète $T_R$ pour assurer la continuité de la trace (voir de tels segments $S_u$, $S_u+_1$, etc... sur la figure 2). Pour bénéficier totalement de l'apport du vecteur d'interpolation, il est nécessaire que le tracé de ce vecteur possède la meilleure résolution possible ; pour ce faire, le balayage de type télévision est utilisé en mode entrelacé, mais présente l'inconvénient d'introduire un effet de papillotement. En effet, lorsqu'une partie de la trace est horizontale ou très faiblement inclinée, cette partie ne concerne qu'une seule ligne de balayage et n'est donc portée que toutes les deux trames, paires ou impaires : l'énergie de cette partie horizontale n'apparaît par exemple que toutes les 40 millisecondes à la fréquence de 25 hertz (au lieu de toutes les 20 millisecondes en balayage non entrelacé à 50 hertz), ce qui est en deçà des possibilités d'intégration de l'œil. Un phénomène désagréable de pulsation d'énergie lumineuse, l'effet de papillotement, est alors ressenti par l'observateur. Le brevet français N° 2 447 122 décrit bien un circuit interpolateur de trames dans lequel on prévoit d'éviter à l'affichage des phénomènes perturbateurs tels que le papillotement vertical des images, mais pour des images présentant des plages.

Le but de l'invention est de proposer un dispositif d'affichage à balayage récurrent entrelacé de type télévision dans lequel est prévu un circuit de traitement éliminant cet effet de papillotement, mais seulement lorsque la trace lumineuse présente effectivement des parties horizontales ou faiblement inclinées.

L'invention concerne à cet effet un dispositif d'affichage à balayage récurrent entrelacé de type télévision, comprenant, pour supprimer l'effet de pulsation lumineuse des segments de la trace lumineuse à afficher, des moyens de traitement associant à des segments d'énergie déterminée portés par une ligne de l'une des trames d'autres segments parallèles dit d'antipapillotement, d'énergie deux fois plus faible et portés chacun par l'une des deux lignes de l'autre trame qui encadrent la ligne considérée dans la première trame, caractérisé en ce que lesdits moyens de traitement ne sont mis en action qu'après détection, à l'aide d'une voie dite de test, de l'existence des situations qui correspondent à la présence de parties horizontales dans l'une des trames.

Pour des considérations de coût, on serait conduit, en option, à n'utiliser qu'un seul segment d'antipapillotement lorsque la trace lumineuse est faiblement ascendante ou descendante. Dans le cas d'une partie de trace parfaitement horizontale, c'est la solution complète qui est retenue : deux segments d'antipapillotement sont associés au segment d'interpolation, et il leur correspond globalement un paquet d'énergie lumineuse ayant la même valeur que celle du segment d'interpolation (puisque ces deux segments ont chacun une énergie deux fois plus faible) et le même centre de gravité (puisque ces deux segments sont identiques et placés symétriquement). La cadence lumineuse se trouve ainsi portée par exemple à 50 hertz dans le cas précédemment cité du balayage entrelacé à 25 hertz, sans que la légère augmentation de largeur de trace qui se produit à l'endroit où est effectué ce traitement antipapillotement soit gênante. Au contraire, ce traitement, visuellement agréable puisqu'il reporte la pulsation d'énergie lumineuse à une fréquence double, assure la conservation du centre de gravité du signal et n'altère donc pas la précision de la mesure effectuée par l'œil dans l'examen d'un oscillogramme. Mais surtout, conformément à l'invention, le traitement n'est utilisé que de place en place sur la trace, uniquement pour ses parties horizontales ou faiblement inclinées, ce qui conserve aux autres parties de la trace leur finesse et leur résolution maximale.

D'autres particularités et avantages de l'invention apparaîtront maintenant de façon plus précise dans la description qui suit et dans les dessins annexés, donnés à titre d'exemple non limitatif et dans lesquels :

les figures 1 et 2 mettent en évidence le principe déjà connu d'interpolation entre les échantillons d'un signal, respectivement dans le cas où le vecteur d'interpolation comprend plusieurs segments horizontaux et dans le cas où il n'y a pas de ligne de balayage disponible entre deux échantillons et où le vecteur d'interpolation comprend donc un segment d'interpolation unique ;

la figure 3 est un schéma fonctionnel du circuit de traitement antipapillotement ;

la figure 4 montre pour la ligne courante « L » les différentes situations dans lesquelles il est utile de générer des segments d'antipapillotement ;

la figure 5 montre le principe de construction des segments de suppression du phénomène de papillotement ;

la figure 6 illustre ce même principe, d'une part dans le cas où l'on prévoit deux segments, et d'autre part dans celui où l'on n'en prévoit qu'un seul, choisi selon le sens d'inclinaison de la trace lumineuse ;

la figure 7 est le tableau de décodage d'une expression Delta définie pour la recherche, conformément à l'invention, des situations où le traitement antipapillotement est nécessaire ;

les figures 8a à 8g décrivent en détail un jeu de circuits logiques qui, à partir des valeurs possibles de l'expression Delta, permet la délivrance d'un signal indicateur de la présence desdites situations et destiné à commander le fonctionnement du dispositif de traitement antipapillotement.

On a vu ci-dessus que le dispositif d'affichage selon l'invention est utile lorsque, en fonction de l'allure locale de la grandeur à représenter sur l'écran d'affichage, la trace, après toutes les interpolations, est constituée en certains endroits de longs segments horizontaux n'appartenant chacun qu'à une seule trame. C'est dans de tels cas que l'énergie liée à ces parties de trame apparaît à une cadence de 25 hertz et est pénible pour l'œil.

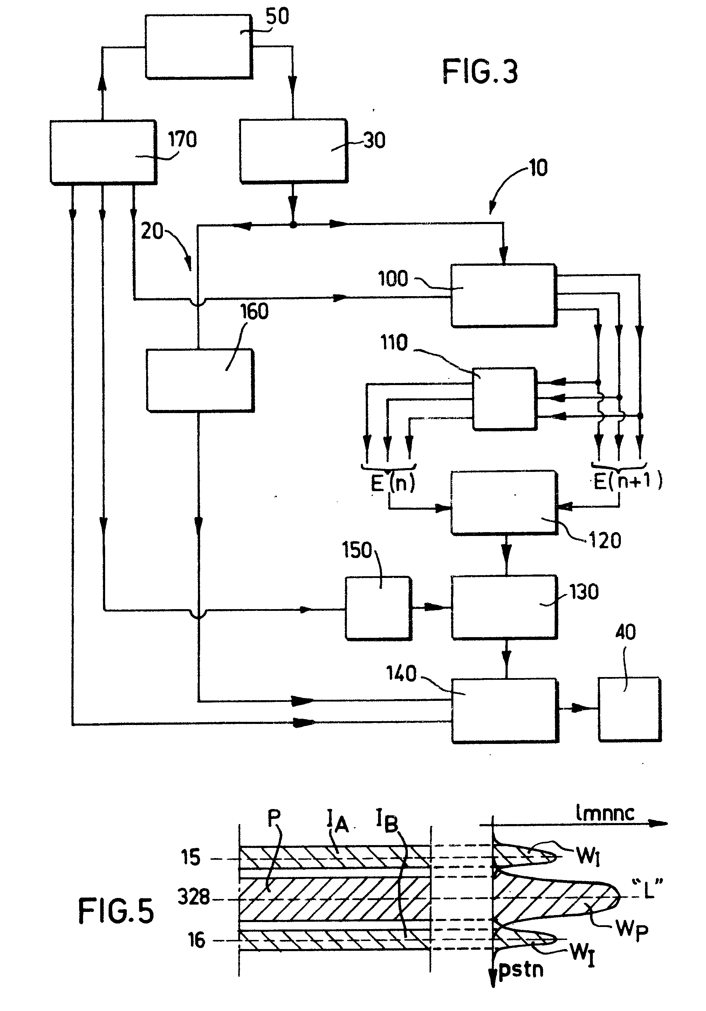

Pour déceler de telles situations, le dispositif d'affichage selon l'invention comprend, conformément au schéma fonctionnel de la figure 3, une voie 10 dite de test, placée en parallèle sur une voie vidéo 20 de restitution de la trace par interpolation, qui relie une mémoire numérique 30 et un écran d'affichage 40. La mémoire numérique 30 contient, bien entendu, la séquence régulière des valeurs numériques représentant les amplitudes respectives des échantillons du signal échantillonné présenté à l'oscilloscope (à raison d'une valeur d'amplitude par unité de temps fixée par la fréquence d'échantillonnage), le contenu de cette mémoire étant renouvelable au rythme fixé par le dispositif d'acquisition non représenté de l'oscilloscope (par exemple toutes les images, ou à un rythme plus lent). A cette mémoire 30 est associé un dispositif 50 de lecture de la mémoire, couplé au déplacement du spot le long d'une ligne de balayage.

La voie de test 10, qui fonctionne à la cadence de restitution des échantillons, par exemple 5 mégahertz, fixée par un séquenceur 170, comprend un détecteur 100 de la position des échantillons successivement délivrés par la mémoire 30 par rapport à la ligne courante repérée par la référence « L » sur la figure 1. Le détecteur 100 reçoit d'une part la sortie de la mémoire 30, et d'autre part l'extrémité d'une connexion de sortie du séquenceur 170 (connexion qui véhicule ladite information « L » du numéro de position de la ligne dans la hauteur d'écran), et présente trois sorties distinctes selon le résultat de la comparaison entre « L » et la position de l'échantillon concerné E(n). Ce détecteur 100 comprend un premier comparateur qui indique si « L » est égal, supérieur ou inférieur à la position de E(n), et un deuxième comparateur assisté d'un additionneur pour comparer L à E(n + 1). Le détecteur 100 est suivi d'un circuit à retard 110 qui retarde (d'une durée égale à $T_R$, période de restitution, ou écart temporel entre deux échantillons successifs) l'information de position obtenue dans le détecteur 100 relativement à l'échantillon E(n) de position horizontale n pendant qu'à nouveau s'élabore une information de position, concernant cette fois l'échantillon suivant E(n + 1) de position n + 1. Si « L » est donc le numéro d'ordre donnant la position de la ligne en cours de balayage dans la hauteur d'écran (cette ligne étant repérée sur la figure 4 par un 0, les deux lignes immédiatement supérieures et inférieures étant repérées respectivement par + 1, + 2 et − 1, − 2), six positions relatives des échantillons correspondent, comme le montre la figure 4, à ces situations où le traitement antipapillotement doit être utilisé dans le dispositif d'affichage.

Un circuit de comparaison et de décision 120 génère un signal indicateur particulier (appelé AP) si l'existence de l'une de ces positions relatives est constatée, et ce signal indicateur commande alors la mise en fonctionnement d'un générateur 130 de traitement antipapillotement, qui piloté à la même cadence de restitution des échantillons que précédemment (5 mégahertz dans l'exemple précédent) pour assurer la synchronisation ultérieure avec le signal vidéo de la trace interpolée, consiste en une bascule bistable convertissant le signal indicateur en un segment horizontal de durée égale à celle qui sépare deux échantillons successifs devant apparaître sur l'une seulement ou, selon le cas, sur les deux lignes de numéro (L − 1) et (L + 1) de l'autre trame. Lorsque le circuit de comparaison et de décision 120 constate au cours du balayage de la ligne courante « L » d'une trame l'existence de l'une des six positions relatives d'échantillons précisées sur la figure 4, c'est-à-dire l'existence graphique d'une partie de signal horizontale ou faiblement inclinée située sur l'une ou sur l'autre des deux lignes graphiques voisines appartenant à la deuxième trame, le générateur 130 commande la construction, sur ladite ligne courante de la première trame, d'un segment parmi un ou deux segments de suppression du phénomène de papillotement, parallèles, de même longueur et d'énergie ici deux fois plus faible que celle du segment d'interpolation graphique situé sur ladite deuxième trame ; le deuxième segment d'antipapillotement sera alors construit au cours du balayage de la prochaine ligne courante de la même première trame. Le principe de cette construction est représenté sur la figure 5, où, en vue très agrandie, est représenté sur une ligne, la ligne 328 de la trame paire par exemple, un tel segment horizontal P de la trace lumineuse reconstruite par interpolation, porteur d'une énergie $W_P$ ; les lignes 15 et 16 de la trame impaire, encadrant la ligne 328, portent alors deux segments $I_A$ et $I_B$ qui encadrent le segment P et sont porteurs chacun d'une énergie $W_1 = W_p/2$, avec une longueur égale à celle des segments d'interpolation et une amplitude deux fois plus faible que ceux-ci.

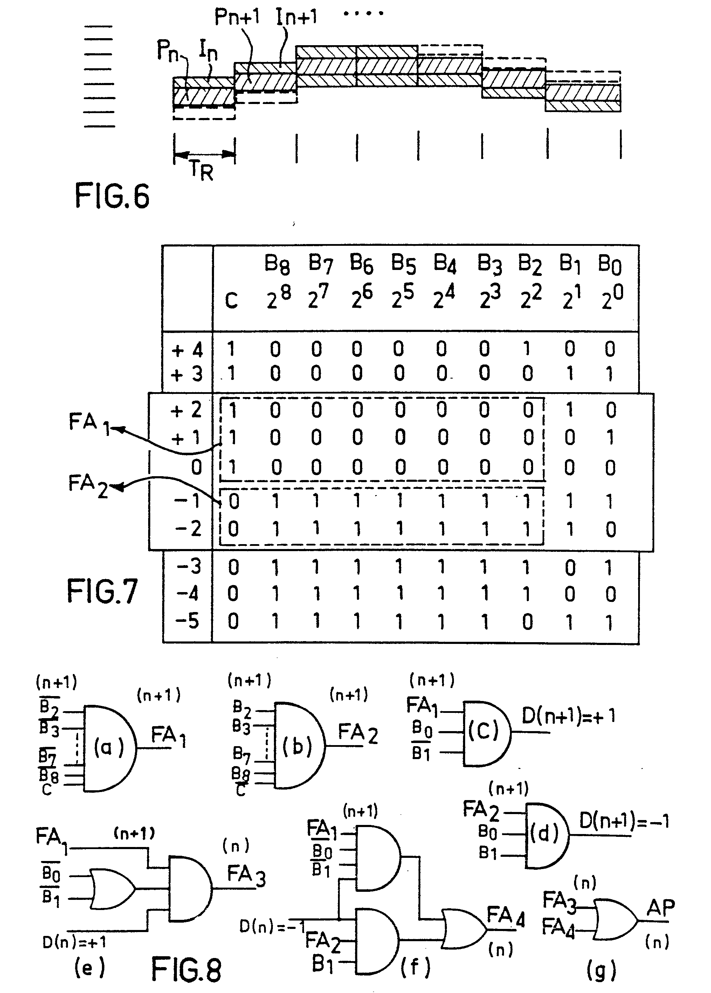

Dans le cas où le segment marqué par le phénomène de papillotement est non pas horizontal mais faiblement incliné, il est possible (voir la figure 6) de n'effectuer la construction, sur la deuxième trame, que d'un seul des deux segments parallèles d'antipapillotement encadrant le segment initial : celui qui se trouve, par rapport audit segment initial $P_n$, du côté vers lequel s'effectue la progression inclinée de la trace, c'est-à-dire le segment $I_n$ situé du côté où se trouve le prochain segment initial $P_{n+1}$ également marqué par le phénomène de papillotement.

L'un des modes de réalisation possibles du circuit 120 de comparaison et de décision présent dans la voie 10 est le suivant. Si le numéro de la ligne « L » peut varier de 0 à 511 (on se limite à 512 lignes utiles) et également la valeur « E » définissant la position des échantillons, « L » et « E » sont définis par des nombres binaires de 9 bits à partir desquels on peut définir l'expression Delta = $D = E - L$ avec 9 bits plus 1 bit éventuel de retenue, soit dix bits $B_0$ à $B_8$ plus le bit de retenue C. L'examen de la figure 4 a montré que le traitement antipapillotement est utilisable dans six situations déterminées de l'échantillon $E(n + 1)$ par rapport à l'échantillon $E(n)$. Le signal indicateur AP de commande du générateur 130 apparaît donc seulement dans ces six situations, conformément à l'équation logique suivante :

$$AP = AP_1 + AP_2$$

avec :

$$AP_1 = |\ D(n) = + 1\ | \cdot |\ (D(n + 1) = 0) + (D(n + 1) = + 1) + (D(n + 1) = + 2)|$$

$$AP_2 = |\ D(n) = - 1\ | \cdot |\ (D(n + 1) = 0) + (D(n + 1) = - 1) + (D(n + 1) = - 2)|$$

les opérateurs étant bien entendu dans ces expressions des opérateurs logiques (le signal AP doit être utilisé globalement pour des traces rigoureusement horizontales, sinon l'énergie d'antipapillotement résultante ne pourrait pas garder le même centre de gravité que l'énergie correspondant à la trace exacte du signal, et le traitement antipapillotement générerait alors une vibration apparente verticale de cette trace restituée).

On a choisi, dans l'exemple ici décrit, d'exprimer Delta en code binaire complément à deux, ce qui donne pour cette expression le tableau de décodage de la figure 7, avec en abscisse les numéros des bits et en ordonnées les numéros des lignes. On constate sur ce tableau qu'on peut définir les fonctions logiques auxiliaires suivantes, à l'aide de deux portes ET (voir les figures 8a et 8b respectivement) :

$$FA_1 = \bar{B}_2 \times \bar{B}_3 \times \bar{B}_4 \times \bar{B}_5 \times \bar{B}_6 \times \bar{B}_7 \times \bar{B}_8 \times C$$

$$FA_2 = B_2 \times B_3 \times B_4 \times B_5 \times B_6 \times B_7 \times B_8 \times \bar{C}$$

De l'expression de ces deux fonctions, on déduit les expressions logiques de $D(n + 1) = + 1$ et de $D(n + 1) = - 1$, à l'aide également d'une simple porte ET dans chaque cas (voir les figures 8c et 8d respectivement) :

$$|\ D(n + 1) = + 1\ | = (FA_1 \times B_0 \times \bar{B}_1)_{n+1}$$

$$|\ D(n + 1) = - 1\ | = (FA_2 \times B_0 \times B_1)_{n+1}$$

On peut alors définir les fonctions logiques auxiliaires $FA_3$ et $FA_4$ destinées à exprimer $AP_1$ et $AP_2$ (voir les figures 8e et 8f respectivement) :

$$FA_3 = FA_{1(n+1)} \times (\bar{B}_0 + \bar{B}_1)_{(n+1)} \times (D(n) = + 1)$$

$$FA_4 = |\ FA_{1(n+1)} \times \bar{B}_{0(n+1)} \times \bar{B}_{1(n+1)} \times (D(n) = - 1)|$$

$$+ |\ FA_{2(n+1)} \times B_{1(n+1)} \times (D(n) = - 1)|$$

Finalement, le signal indicateur AP apparaît si l'une au moins des fonctions $FA_3$ ou $FA_4$ est présente sur les entrées d'une porte OU, représentée sur la figure 8g et en sortie de laquelle est présent AP, signal de commande du générateur 130 de traitement antipapillotement, qui reçoit par ailleurs d'un circuit 150 de synchronisation relié au séquenceur 170 la cadence de restitution des échantillons.

4

Le signal antipapillotement, composé comme on l'a vu de deux segments portés par une trame entourant le segment initial d'interpolation porté par l'autre trame, est alors délivré en sortie de la voie 10 de test et de traitement, pour composition dans un additionneur analogique 140 avec le signal vidéo de la trace interpolée issu du circuit 160 de reconstruction du signal par les vecteurs d'interpolation et avec le signal de synchronisation du récepteur et le signal de réticule électronique tous deux issus d'un séquenceur 170, puis est envoyé sur l'écran d'affichage 40. On notera ici que la voie vidéo 20 de restitution de la trace par interpolation comprend un circuit à retard, non représenté, apportant aux signaux qui la traversent un retard multiple de la période de restitution $T_R$ et destiné à permettre au niveau de l'additionneur 140 la synchronisation avec les signaux de sortie de la voie 10.

La nouvelle trace lumineuse obtenue, un peu plus large mais non doublée, est désormais exempte de tout papillotement. En outre, comme la somme de l'énergie des deux segments d'antipapillotement ajoutés est égale à l'énergie du segment d'interpolation initial, le centre de gravité de cette nouvelle énergie est identique à celui de l'énergie de ce segment initial, et il n'y a aucune génération d'erreur sur la position de la trace lumineuse, aucun décalage du centre de celle-ci par rapport aux autres parties de la trace qui n'ont pas subi le traitement antipapillotement, ce qui préserve la précision des mesures.

Bien entendu, la présente invention n'est pas limitée aux exemples de réalisation ci-dessus décrits et représentés, à partir desquels des variantes peuvent être proposées sans pour cela sortir du cadre de l'invention. En particulier, il est possible, en ce qui concerne les figures 8a à 8g, d'utiliser un jeu de circuits logiques différent si l'on veut tenir compte des résultats partiels issus de la voie 20 d'interpolation. Par ailleurs, il est possible, bien que cette solution soit actuellement plus coûteuse, de prévoir une mémoire de trame stockant le résultat des opérations faites sur la trame précédente.

## Revendications

1. Dispositif d'affichage à balayage récurrent entrelacé de type télévision, comprenant, pour supprimer l'effet de pulsation lumineuse des segments de la trace lumineuse à afficher, des moyens de traitement (130) associant à des segments (P) d'énergie déterminée portés par une ligne de l'une des trames d'autres segments parallèles (I) dit d'antipapillotement, d'énergie plus faible et portés chacun par l'une des deux lignes de l'autre trame qui encadrent la ligne considérée dans la première trame, caractérisé en ce que lesdits moyens de traitement (130) ne sont mis en action qu'après détection, à l'aide d'une voie (10) dite de test, de l'existence des situations qui correspondent à la présence de parties horizontales dans l'une des trames.

2. Dispositif selon la revendication 1, caractérisé en ce que cette voie (10) de test comprend un circuit logique comparant les positions d'échantillons successifs de la trace lumineuse par rapport à la ligne courante (L) du balayage et délivrant un signal indicateur de commande des moyens de traitement (130) si l'existence de l'une de ces situations est déduite du résultat de ladite comparaison.

3. Dispositif selon l'une des revendications 1 et 2, caractérisé en ce que l'énergie du ou des segments d'antipapillotement est deux fois plus faible que celle du segment d'interpolation graphique.

4. Oscilloscope numérique à balayage récurrent entrelacé de type télévision, caractérisé en ce qu'il comprend un dispositif d'affichage selon l'une des revendications 1 et 2.

## Claims

1. A television-type interlaced display device comprising, to suppress the effect of light fluctuations of segments of the light trace to be displayed, processing means (130) which are associated with segments (P) having a predetermined energy and located on a line of one of the fields, further parallel so-called anti-flicker segments (I) of a lower energy being located in one of two lines of the other field enclosing the relevant line in the first field, characterized in that the said processing means (130) are only made operative when, by means of a test path (10), the occurrence of situations corresponding to the presence of horizontal portions in one of the fields is detected.

2. A device as claimed in Claim 1, characterized in that said test path (10) comprises a logic circuit which compares the positions of consecutive samples of the light trace relative to the moving scanning line (L) and supplies a control indication signal for the processing means (130) if the existence of one of these situations is determined from the result of the said comparison.

3. A device as claimed in one of the Claims 1 and 2, characterized in that the energy of the anti-flicker segment or segments is two times weaker than the energy of the graphic interpolation segment.

4. A television-type interlaced display digital ocilloscope, characterized in that at comprises a display device as claimed in one of the Claims 1 and 2.

## Patentansprüche

1. Anzeigeeinrichtung mit Zeilensprungabtastung vom Fernsehtyp die zum Unterdrücken des Flimmereffektes von Segmenten der wiederzugebenden Lichtspur Bearbeitungsmittel (130) enthält zur Zuordnung an die Segmente (P) von, eine vorbestimmte Energie aufweisenden, auf einer Zeile eines der Teilbilder liegenden, parallelen sogenannten Anti-Flimmersegmenten (I) mit einer geringeren Energie, die auf einer von zwei Zeilen des anderen Teilbildes liegen, wobei diese zwei Zeilen die betreffende Zeile des ersten Teilbildes einschliessen, dadurch gekennzeichnet, dass die genannten Bearbeitungsmittel (130) nur wirksam gemacht werden, wenn mittels einer Teststrecke (10) das Auftreten von Situationen entsprechend dem Vorhandensein horizontaler Teile in einem der Teilbilder detektiert wird.

2. Einrichtung nach Anspruch 1, dadurch gekennzeichnet, dass diese Teststrecke (10) eine logische Schaltungsanordnung aufweist, welche die Positionen aufeinanderfolgender Abtastwerte der Lichtspur in bezug auf die jetzige Abtastlinie (L) vergleicht und ein Anzeigesteuersignal für die Bearbeitungsmittel (130) liefert, wenn das Vorhandensein einer dieser Situationen aus dem Ergebnis des genannten Vergleiches ermittelt wird.

3. Einrichtung nach einem der Ansprüche 1 und 2, dadurch gekennzeichnet, dass die Energie des Anti-Flimmersegmentes bzw. der Anti-Flimmersegmente zweimal weniger ist als die Energie des graphischen Interpolationssegmentes.

4. Digitales Oszilloskop mit Zeilensprungsverfahren nach Fernsehart, dadurch gekennzeichnet, dass es eine Wiedergabeeinrichtung nach einem der Ansprüche 1 und 2 aufweist.

FIG. 1

$S_m$

$E(n+1)$

"L"

$S_2$

$E(n)$

$S_1$

$T_R$

FIG. 2

20
333
21
334
22
335
23
336
24
337
25
338
26
339
27
340
28
341

$S_u$

$S_{u+1}$

0 | 1 | 2 | 3 | 4 | 5 | 6 | 7

$T_R$     $T_R$     $T_R$     $T_R$

+2

$E(n+1)$

$E(n)$     $E(n)$     $E(n+1)$

FIG. 4

+1

$E(n)$

"L": 0

$E(n+1)$

−1

$E(n+1)$     $E(n)$

$E(n)$     $E(n)$     $E(n+1)$

−2

$E(n+1)$

1

FIG.3

FIG.5

FIG.6

| | C | $B_8$ $2^8$ | $B_7$ $2^7$ | $B_6$ $2^6$ | $B_5$ $2^5$ | $B_4$ $2^4$ | $B_3$ $2^3$ | $B_2$ $2^2$ | $B_1$ $2^1$ | $B_0$ $2^0$ |
|---|---|---|---|---|---|---|---|---|---|---|
| + 4 | 1 | 0 | 0 | 0 | 0 | 0 | 0 | 1 | 0 | 0 |
| + 3 | 1 | 0 | 0 | 0 | 0 | 0 | 0 | 0 | 1 | 1 |
| + 2 | 1 | 0 | 0 | 0 | 0 | 0 | 0 | 0 | 1 | 0 |
| + 1 | 1 | 0 | 0 | 0 | 0 | 0 | 0 | 0 | 0 | 1 |
| 0 | 1 | 0 | 0 | 0 | 0 | 0 | 0 | 0 | 0 | 0 |
| − 1 | 0 | 1 | 1 | 1 | 1 | 1 | 1 | 1 | 1 | 1 |
| − 2 | 0 | 1 | 1 | 1 | 1 | 1 | 1 | 1 | 1 | 0 |
| − 3 | 0 | 1 | 1 | 1 | 1 | 1 | 1 | 1 | 0 | 1 |
| − 4 | 0 | 1 | 1 | 1 | 1 | 1 | 1 | 1 | 0 | 0 |
| − 5 | 0 | 1 | 1 | 1 | 1 | 1 | 1 | 0 | 1 | 1 |

$FA_1$  $FA_2$  FIG.7

(e)   FIG.8   (f)   (g)

3